# FASCICULE DE BREVET EUROPEEN

(11) **EP 0 803 982 B1**
(45) Date de publication et mention de la délivrance du brevet: **17.01.2001**
(21) Numéro de dépôt: 97400935.9
(22) Date de dépôt: 24.04.1997
(51) Int. Cl.: H03K 19/177, G06F 15/18

(54) **Système électronique organisé en un réseau matriciel de cellules fonctionnelles**
Elektronisches System mit einem matrixförmigen Netz aus funktionellen Zellen
Electronic system organized in a matrix array of functional cells

(30) Priorité: 26.04.1996 FR 9605320
(43) Date de publication de la demande: 29.10.1997
(73) Titulaire: C.S.E.M. CENTRE SUISSE D'ELECTRONIQUE ET DE MICROTECHNIQUE SA, 2007 Neuchâtel (CH)
(72) Inventeur: Marchal, Pierre, 2042 Valangin (CH); Piguet, Christian, 2000 Neuchatel (CH); Nussbaum, Pascal, 2016 Cortaillod (CH)
(74) Mandataire: Caron, Gérard

(56) Documents cités:
- EP-A- 0 626 760
- WO-A-95/17781
- INTERNATIONAL CONFERENCE ON NEURAL NETWORKS/ WORLD CONGRESS ON COMPUTATIONAL INTELLIGENCE, ORLANDO, JUNE 27 - 29, 1994, vol. 4, 27 juin 1994, INSTITUTE OF ELECTRICAL AND ELECTRONICS ENGINEERS, pages 2321-2326, XP000509809 MARCHAL P ET AL: "ACHIEVING VON NEUMANN'S DREAM: ARTIFICIAL LIFE ON SILICON"

## Description

La présente invention est relative aux systèmes électroniques intégrés programmables comportant, pour réaliser ses fonctionnalités, un réseau matriciel de cellules, toutes identiques et configurables pour les fonctions qu'elles doivent accomplir.

De tels systèmes, déjà connus dans leur principe, peuvent être dotés de diverses fonctions intrinsèques de tolérance aux pannes des cellules grâce à leur capacité à s'adapter eux-mêmes à la panne afin de pouvoir pérenniser leurs fonctionnalités.

Un réseau de ce type est décrit dans la demande de brevet européen EP-A-0 626 760 déposée le 20 mai 1994 au nom du Demandeur et intitulée: "Système électronique organisé en réseau matriciel de cellules". Dans ce système, des cellules sont regroupées en un réseau qui comporte des moyens pour propager un "génome" composés de "gènes" à travers les cellules du réseau afin de les activer pour les fonctions qu'elles ont à remplir dans le système. On entend ici par "gène", un mot binaire de code comprenant toutes les informations nécessaires pour placer une cellule donnée dans la configuration fonctionnelle souhaitée. IEEE 1994 INTERNATIONAL CONFERENCE ON NEURAL NETWORKS/WORLD CONGRESS ON COMPUTATIONAL INTELLIGENCE, ORLANDO, June 27-29, 1994, vol. IV, 27 juin 1994, INSTITUTE OF ELECTRICAL AND ELECTRONICS ENGINEERS, pages 2321-2326, XP000509809, MARCHAL P. et al.: "Achieving von Neumann's Dream: Artificial Life on Silicon" divulgue un état de la technique similaire et mentionne la possibilité d'une décomposition hiérarchique d'un tel réseau en sous-unités, ou organes fonctionnels.

L'invention a pour but de perfectionner le réseau décrit dans la demande de brevet précitée afin de réduire la taille du génome, de diminuer l'influence des pannes en limitant celles-ci à l'organe affecté et de permettre, plus généralement, une meilleure souplesse d'organisation des fonctions devant être réalisées par le réseau.

L'invention a donc pour objet un réseau matriciel composé de cellules toutes de construction identique et dans lequel à chaque cellule est affecté un mot de code qui en définit la fonction qu'elle doit assurer au sein du réseau, ledit réseau comportant des moyens qui, en vue de la configuration des cellules, font translater itérativement dans chacune desdites cellules un génome formé d'un train desdits mots de code successifs, caractérisé en ce qu'il comprend au moins un organe fonctionnel individualisé composé d'une pluralité desdites cellules qui sont toutes caractérisées par un premier code prédéterminé faisant partie dudit mot de code et formé par un numéro identifiant ledit organe afin que ces cellules puissent assurer collectivement la fonctionnalité dudit organe, lesdites cellules de l'organe étant réparties en un premier groupe de cellules dites internes définies par une première valeur prédéterminée d'un second code ou code de statut faisant également partie dudit mot de code, et en une seconde groupe de cellules dites de membrane et définies par une seconde valeur prédéterminée dudit second code, ledit premier groupe de cellules assurant la fonctionnalité dudit organe et ledit second groupe de cellules formant membrane capable d'isoler fonctionnellement ledit premier groupe de cellules du reste du réseau et d'assurer la communication de ce premier groupe de cellules avec le reste dudit réseau.

Il résulte de ces caractéristiques que les cellules de l'organe fonctionnel peuvent être configurées et identifiées moyennant un volume d'information relativement faible ce qui permet de diminuer la taille du génome nécessaire pour configurer le réseau. Par ailleurs, il devient possible d'assurer à l'intérieur de chaque organe une meilleure souplesse de gestion de la fonctionnalité notamment par la faculté d'auto-réparation dont peut être doté un organe fonctionnel.

D'autres caractéristiques et avantages de l'invention apparaîtront au cours de la description qui va suivre, donnée uniquement à titre d'exemple et faite en se référant aux dessins annexés sur lesquels:
- la figure 1 est un schéma très simplifié d'un réseau selon l'invention;
- la figure 2 est le schéma général d'une cellule du réseau de la figure 1;
- les figures 3, 3A et 3B sont des schémas plus détaillés d'une cellule du réseau selon l'invention;
- la figure 4 montre une partie du réseau selon l'invention pour illustrer le processus de configuration des cellules;
- les figures 5, 6 et 7 montrent des vues analogues à celle de la figure 4 respectivement après écoulement de 58, 116 et 174 cycles d'une horloge commandant la configuration des cellules;
- la figure 8 est un diagramme montrant la répartition d'un code de membrane dans les cellules d'un organe devant être créé dans le réseau selon l'invention;
- la figure 9 est un diagramme montrant la répartition d'un code de statut dans les cellules de l'organe à créer;
- les figures 10 à 14 montrent la croissance de l'organe fonctionnel respectivement après 232, 290, 348, 406 et 464 cycles de l'horloge de base commandant cette croissance; et
- les figures 15A, 15B et 15C montrent pour certaines cellules de l'organe fonctionnel comment se termine sa croissance.

Dans la présente description, les expressions énumérées ci-après ont les significations suivantes:
- Génome: Train de mots de code parcourant de manière cyclique toutes les cellules du réseau matriciel et à partir duquel les cellules déterminent leur fonctionnalité.
- Gène: Partie d'un mot de code du génome affectée respectivement à chaque cellule pour mettre en place la fonction qu'elle doit remplir.
- Organe: Ensemble d'un certain nombre de cellules du réseau affectées à une tâche donnée.
- Membrane: Groupe de cellules particulières qui ceinture les cellules fonctionnelles d'un organe dans le réseau et fait partie dudit organe.
- Adresse globale: Partie d'un mot de code définissant l'emplacement d'une cellule dans le réseau.
- Adresse locale: Partie d'un mot de code définissant l'emplacement d'une cellule dans un organe du réseau.
- En-tête: Partie d'un mot de code contenant un code de statut.
- Zygote: Cellule de base d'un organe dont l'adresse globale détermine l'emplacement à partir duquel se développe la croissance d'un organe dans le réseau.

Par ailleurs, les termes "Ouest" et "Sud" (et éventuellement, "Nord" et "Est") utilisés par la suite désignent ici, arbitrairement et pour la commodité de la description, les directions dans le réseau matriciel, comportant un très grand nombre de cellules que l'on doit se représenter situées dans un plan et localisées à la façon des cartes routières par exemple, selon les directions cardinales de la rose des vents.

On comprendra cependant que l'agencement physique du réseau selon l'invention peut être différent d'une telle disposition planaire, les différentes parties du réseau pouvant être réalisées, par exemple, sur plusieurs puces de circuit intégré disposées selon une conception quelconque en fonction des besoins. Il est également possible de concevoir sur la base du concept de l'invention des réseaux tridimensionnels impliquant un adressage en conséquence.

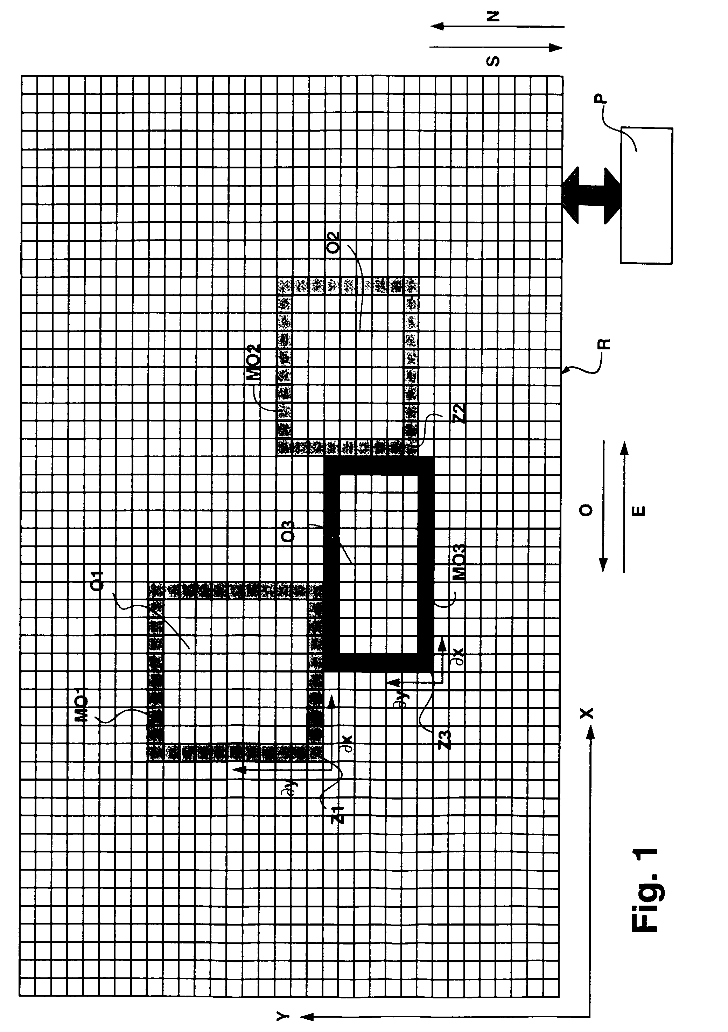

Toutefois, pour décrire l'invention, on se contentera de n'examiner ici qu'un réseau matriciel R suivant l'invention (figure 1) conçu comme un réseau bidimensionnel. Il comporte donc une pluralité de cellules juxtaposées, toutes identiques et agencées dans l'exemple selon deux axes X et Y perpendiculaires. Ainsi, à chaque cellule est affectée une adresse globale constituée par une valeur en X et une valeur en Y.

Le réseau R est commandé par un processeur P qui permet de configurer le réseau à l'initialisation, de le reconfigurer au besoin pendant son fonctionnement et, éventuellement, d'échanger avec lui des signaux de commande et d'information relatifs aux tâches qui doivent être accomplies par le réseau au cours de son fonctionnement.

Selon l'invention, après initialisation, le réseau R présente une certaine hiérarchie parmi les cellules. Ainsi, des organes fonctionnels y sont délimités de par la configuration des cellules lors de l'initialisation. Sur la figure 1, on a représenté à titre d'exemple trois de ces organes O1, O2 et O3, ce nombre n'étant évidemment nullement limitatif.

Chacun de ces organes O1, O2, O3... On a la propriété d'être organiquement distinct des autres organes et/ou cellules du réseau et de former ainsi une entité fonctionnelle autonome capable d'accomplir une fonction déterminée, d'échanger des signaux électriques avec le reste du réseau et/ou avec le processeur P, et de procéder lui-même à la gestion des pannes pouvant frapper les cellules dont il est composé.

Dans chaque organe, les cellules présentent également une hiérarchie entre elles. C'est ainsi que chaque organe comporte une zygote, Z1, Z2, ..., Zn, qui est la cellule de base de l'organe à partir de laquelle, notamment à l'initialisation du réseau, l'organe va être développé. Chaque organe comprend également un groupe de cellules, telles MO1, MO2, ..., MOn, formant ce qui est appelé membrane dans la suite de la description. Une membrane fait le tour d'un organe pour ainsi l'isoler fonctionnellement du reste du réseau R. Les cellules de membrane sont configurées (c'est-à-dire fonctionnellement organisées), à l'aide du gène qui leur correspond, de manière à leur permettre d'assurer l'échange avec l'extérieur (c'est-à-dire avec le reste du réseau et/ou avec le processeur P).

Dans chaque organe, les cellules sont affectées d'une adresse locale qui définit son implantation dans cet organe par rapport à la zygote Z1, Z2, ..., Zn de celui-ci. Les mots de code correspondant à ces cellules ne contiennent donc pas de valeur d'adresse correspondant à leur adresse globale.

La détermination des fonctionnalités des cellules est réalisée au moyen d'un génome que le processeur P peut émettre vers le réseau R. Il s'agit d'un train de signaux binaires répartis en mots de code affectés respectivement aux cellules. Chaque mot de code comporte un groupe de signaux formant le gène d'une cellule. Chaque gène contient tous les signaux ou informations pour configurer la cellule (c'est-à-dire en fixer la fonctionnalité) à laquelle il est destiné. Suivant l'invention, chaque mot de code comporte notamment :
1) une information de statut qui, notamment, qualifie la catégorie de la cellule correspondante. Cette information est également utilisée pour organiser fonctionnellement la cellule et renseigner sur son état,
2) une information d'appartenance définissant le numéro d'organe auquel appartient la cellule considérée,
3) des adresses globale et/ou locale, et
4) une information (ou gène) définissant, si elle est présente, la fonctionnalité de la cellule correspondant à l'adresse locale spécifiée dans le mot de code.

Pour initialiser le réseau R, le génome doit parcourir toutes ses cellules ce qui, dans l'exemple de réalisation qui va être décrit ci-après, est effectué de façon sérielle en décalant le génome dans les cellules sous l'action d'un signal d' horloge générale (non représenté) qui est fourni par le processeur P.

Un mot de code du réseau suivant l'invention se présente comme suit:
<statut><code CMH><@X><@Y><δx><δy><gène>
dans lequel <statut> définit l'information de statut de la cellule, <code CMH> (acronyme emprunté à la biologie cellulaire pour "Complexe Majeur d'Histocompatibilité") l'information d'appartenance à un organe donné, <@X> et <@Y> l'adresse globale de la cellule, <δx> et <δy> son adresse locale et, enfin, <gène> la fonctionnalité de cette cellule. Il est à noter que le gène sert à configurer la cellule, de préférence, de la façon décrite dans la demande de brevet précitée. On n'y reviendra donc pas dans la présente description.

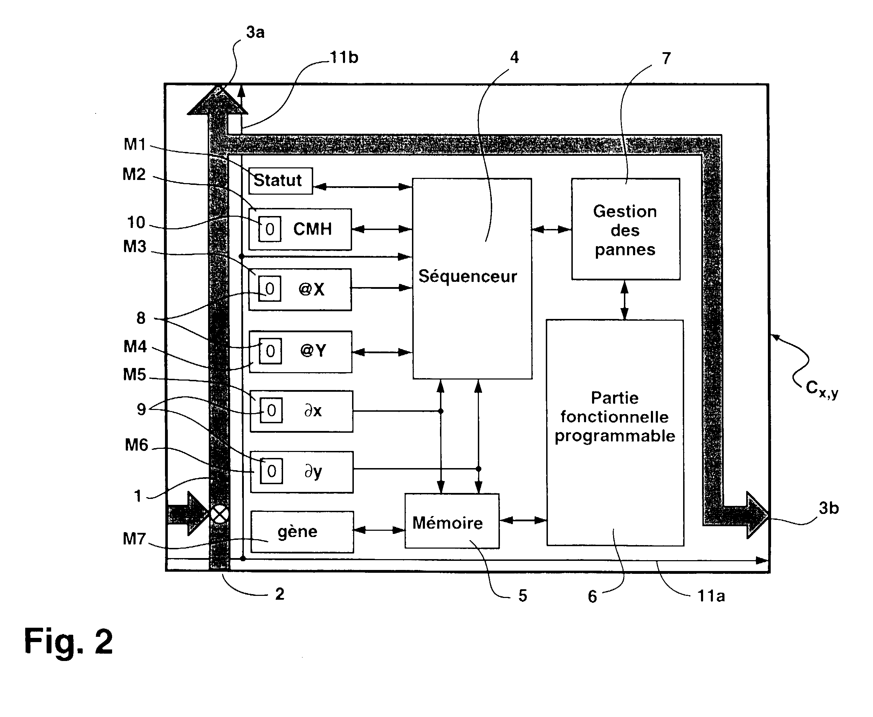

La figure 2 représente un schéma très simplifié d'une cellule du réseau R selon l'invention. Elle est désignée par la référence générale C_{X,Y}. Toutes les cellules du réseau ont la même construction.

La cellule comporte un registre à décalage 1 dans lequel peut transiter le génome. Dans le mode de réalisation décrit, cette transition est sérielle et se fait sous la commande du signal d'horloge engendré par l'horloge générale se trouvant dans le processeur P.

Le registre à décalage 1 a son entrée 2 qui communique avec la sortie du registre à décalage des cellules Sud et Ouest et comporte deux sorties 3a et 3b communiquant, respectivement, avec les entrées des registres à décalage des cellules Nord et Est.

Les positions du registre à décalage 1 sont logiquement en communication avec des modules logiques d'analyse qui sont chargés d'examiner le génome transféré dans le registre 1 et d'y prélever l'information destinée à la cellule considérée.

Ces modules sont:
un module M1 de statut dans lequel est analysé le code de statut;
un module M2 de CMH dans lequel est analysé le code de numéro d'organe;
un module M3 d'adresse globale @X;
un module M4 d'adresse globale @Y;
un module M5 d'adresse locale δx;
un module M6 d'adresse locale δy; et
un module M7 de gène.

La cellule comporte un séquenceur 4 chargé de mettre en oeuvre les différentes phases du séquencement, comme cela apparaîtra dans la suite de la description. La cellule comporte, en outre, un module 5 dans lequel peuvent être mémorisés les gènes de toutes ou d'une partie des autres cellules de l'organe. La cellule comporte également une partie fonctionnelle programmable 6 fonctionnant, de préférence, de la façon décrite dans la demande de brevet précitée. On n'y reviendra donc pas dans la présente description.

La cellule comporte en outre une partie 7 dédiée à la gestion des pannes qui recevra les signaux d'erreur provenant des différents blocs constituant la cellule en fonctionnant de préférence de la façon décrite dans la demande de brevet précitée. On n'y reviendra donc pas dans la présente description. Enfin, chaque cellule comprend des registres 8 et 9, respectivement, d'adresses globale et locale ainsi qu'un registre de code CMH 10.

On va maintenant examiner la création d'un organe fonctionnel O dans le réseau R en décrivant, au fur et à mesure du déroulement du processus de création, les circuits qui sont nécessaires dans chaque cellule, pour la mise en oeuvre de ce processus.

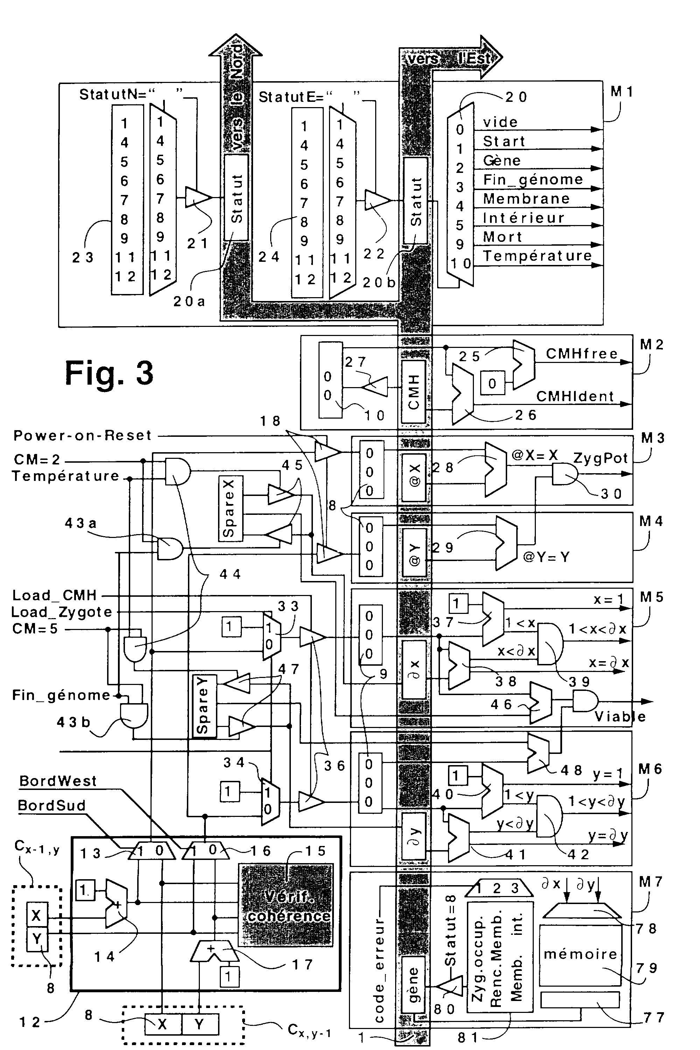

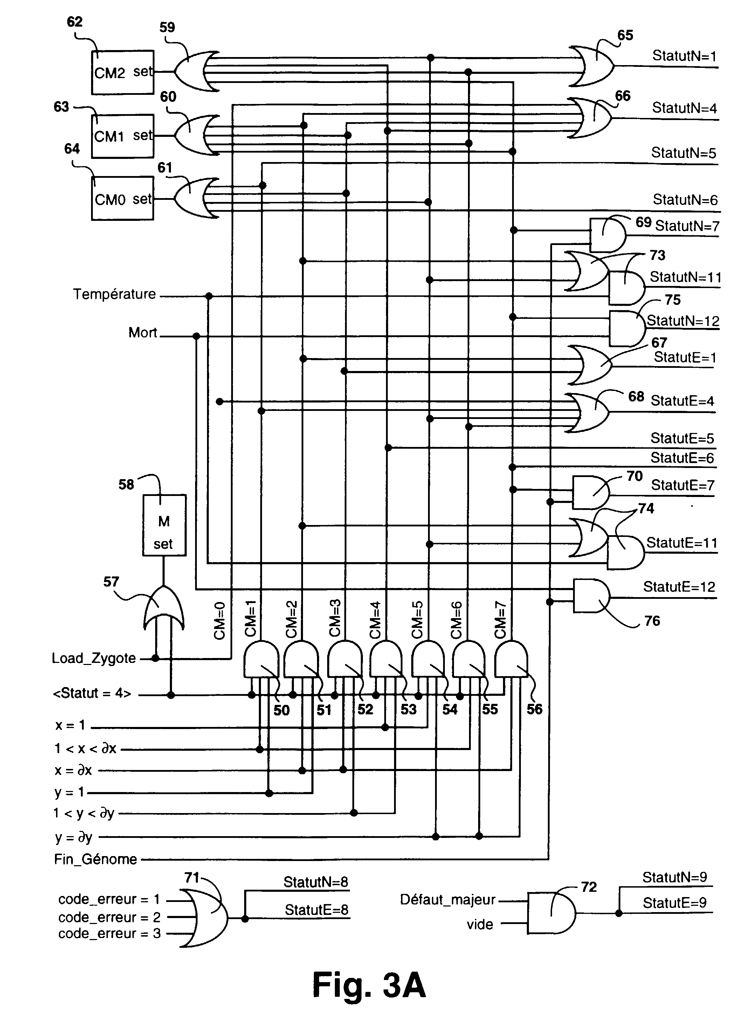

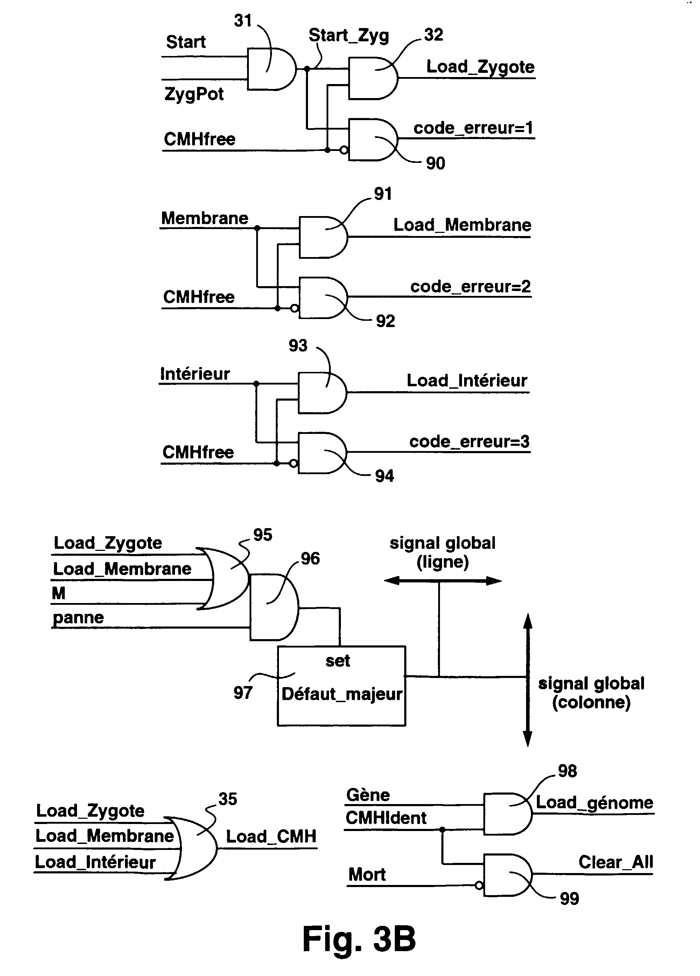

On a représenté sur les figures 3, 3A et 3B un schéma simplifié d'un exemple de réalisation de tels circuits faisant partie de la cellule C_{X,Y}, étant entendu qu'on les retrouve à l'identique dans toutes les cellules du réseau R. Certains de ces circuits appartiennent au séquenceur 4, d'autres aux blocs logiques M1 à M7 ou au module 5 de la cellule.

L'un des circuits, représenté globalement en 12 sur la figure 3, est chargé, lors du démarrage du circuit (signal Power-On-Reset), de calculer l'adresse globale @X et @Y de la cellule C_{x,y}, puis lors du chargement d'un organe, le même circuit est utilisé pour calculer l'adresse locale δx et δy de la cellule C_{x,y}. Dans le mode de réalisation représenté, qui n'est pas limitatif de l'invention, le calcul des adresses globales est avantageusement effectué en utilisant une méthode de redondance permettant de vérifier les transferts et les calculs des valeurs des adresses pour toutes les cellules. Le calcul peut être effectué en série ou en parallèle.

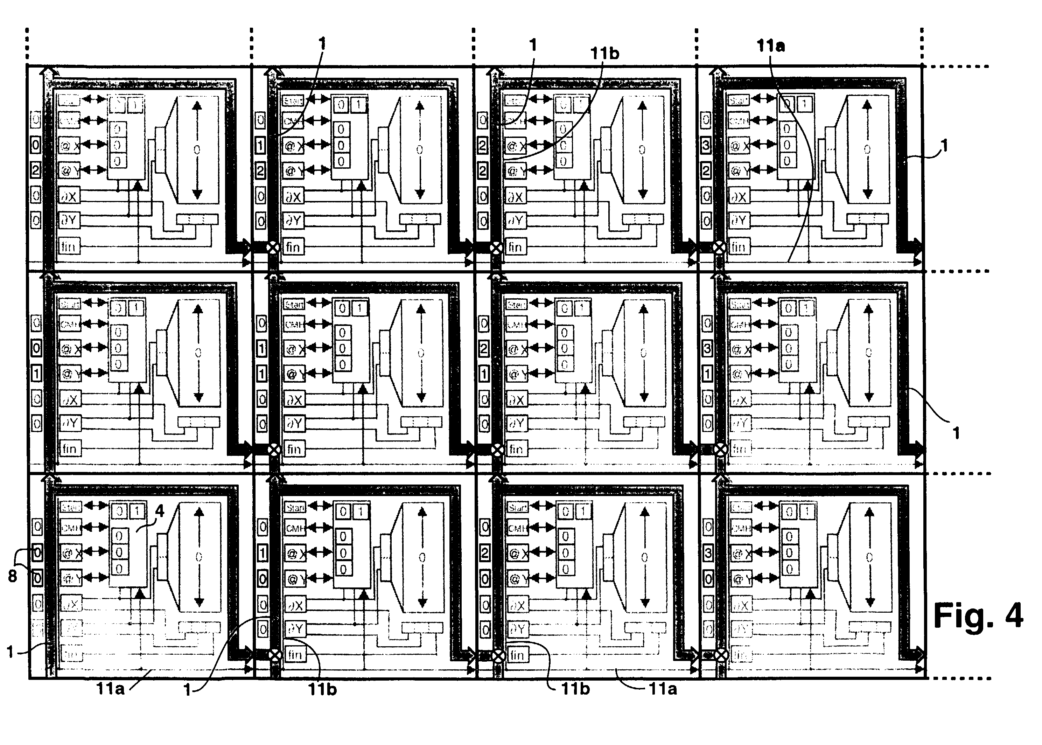

Le calcul des adresses globales est déclenché, à l'initialisation du réseau R, par le processeur P (figure 1) qui produit, à cet effet, un signal de remise à l'état initial (Power-On-Reset). Ce signal provoque le calcul de l'adresse de la "première" cellule du réseau qui a, dans l'exemple, l'adresse 0,0 (Fig. 4). Le calcul des adresses globales s'effectue ensuite de proche en proche dans toutes les cellules de la façon suivante.

L'adresse globale de la cellule C_{X,Y} est calculée à partir de celles des cellules adjacentes C_{X-1,Y} et C_{X,Y-1} dont, sur la figure 3, on n'a représenté que les registres d'adresse globale 8. Le circuit 12 comprend, pour le chargement de la valeur en X de l'adresse globale, un multiplexeur 13 commandé par le signal BordSud. L'entrée "1", valide lorsque le signal BordSud=1, de ce multiplexeur reçoit la valeur d'un incrémenteur 14 qui est relié à la partie X du registre 8 de la cellule C_{x-1,y}. L'entrée "0" du muliplexeur 13, valide lorsque le signal BordSud=0, est reliée à la partie X du registre 8 de la cellule C_{x,y-1}. Dans le cas général, le registre de l'adresse globale reçoit la valeur correspondante de la cellule Sud (C_{x,y-1}) sauf sur le bord Sud du circuit (Y=0) pour lequel il n'y a pas de cellule Sud. Dans ce dernier cas, le calcul est réalisé à partir de la cellule Ouest (C_{x-1,y}) et nécessite alors une incrémentation (grâce à l'incrémenteur 14). Les deux valeurs de X sont envoyées dans le bloc 15 de vérification de cohérence. Si les deux valeurs sont différentes, il y a une anomalie dans le transfert des adresses ou dans le calcul. Grâce à cette redondance du calcul d'adresse, le processeur P peut, par des moyens qui ne sont pas décrits ici, prendre des mesures pour remédier à une anomalie, éventuellement en écartant sur le plan fonctionnel du réseau la cellule dans laquelle l'erreur a été constatée.

Le calcul de l'adresse en Y se déroule de façon tout à fait analogue dans la cellule C_{X,Y}, par le chargement de la partie Y du registre 8 de la cellule C_{X,Y,} au moyen du multiplexeur 16 contrôlé par le signal BordWest, sauf pour la première colonne (BordWest=1) auquel cas il est chargé par la valeur provenant de l'incrémenteur 17 qui est relié à la partie Y du registre 8 de la cellule C_{X,Y-1}.

Les valeurs des signaux BordSud et BordWest peuvent, par exemple, être définis à la construction du réseau ou par le processeur P.

La figure 4 montre la partie extrême Sud-Ouest d'un réseau R dans lequel les cellules ont été chargées de leur adresse globale, l'adresse initiale de la cellule extrême sud-ouest étant ici choisie à la valeur 0,0.

La figure 4 montre également la toute première opération de l'étape du processus de création des organes du réseau, étape qui va se dérouler immédiatement après le chargement des adresses globales dans les cellules, à savoir le passage du génome à travers les registres 1 de toutes les cellules. L'étape est déclenchée par l'émission d'un signal qui est émis par le processeur P dès l'achèvement du chargement des adresses globales et transféré de cellule en cellule sur des conducteurs 11a et 11b se trouvant dans chaque cellule (voir aussi la figure 2). Ce signal déclenche le fonctionnement des séquenceurs 4 de toutes les cellules.

Plus particulièrement, la figure 4 montre la situation à la fin du premier cycle d'horloge de cette étape. On voit donc que le registre à décalage 1 de la cellule d'adresse globale 0,0 a reçu le premier digit du génome qui a ici la valeur "1". En même temps, les compteurs de cycles de toutes les cellules marquent la position "1". A part le registre à décalage 1 de la cellule 0,0, qui a reçu le premier digit, les autres registres à décalage sont encore vides.

L'organe fonctionnel, dont on va décrire la formation à titre d'exemple, présente les mots de code énumérés dans le tableau 1 ci-dessous. (Il est à noter que les valeurs sont données en numération décimale pour faciliter la compréhension. En réalité, les mots de code du génome sont, de préférence, en numération binaire).

**TABLEAU 1**

| N° | statut | CMH | <@X> | <@Y> | <δx>, <x> ou <SPARE> | <δy>, <y> ou <SPARE> | gène |
|---|---|---|---|---|---|---|---|
| 1 | <1> | <23> | <001> | <001> | <04> | <03> | <xx> |
| 2 | <2> | <23> | <-> | <-> | <01> | <01> | <gène 1> |
| 3 | <2> | <23> | <-> | <-> | <02> | <01> | <gène 2> |
| 4 | <2> | <23> | <-> | <-> | <03> | <01> | <gène 3> |
| 5 | <2> | <23> | <-> | <-> | <04> | <01> | <gène 4> |
| 6 | <2> | <23> | <-> | <-> | <01> | <02> | <gène 5> |
| 7 | <2> | <23> | <-> | <-> | <02> | <02> | <gène 6> |
| 8 | <2> | <23> | <-> | <-> | <03> | <02> | <gène 7> |
| 9 | <2> | <23> | <-> | <-> | <04> | <02> | <gène 8> |
| 10 | <2> | <23> | <-> | <-> | <01> | <03> | <gène 9> |
| 11 | <2> | <23> | <-> | <-> | <02> | <03> | <gène 10> |
| 12 | <2> | <23> | <-> | <-> | <03> | <03> | <gène 11> |
| 13 | <2> | <23> | <-> | <-> | <04> | <03> | <gène 12> |
| 14 | <3> | <23> | <-> | <-> | <04> | <03> | <xxxxx> |
| | | | | | (SPARE) | (SPARE) | |

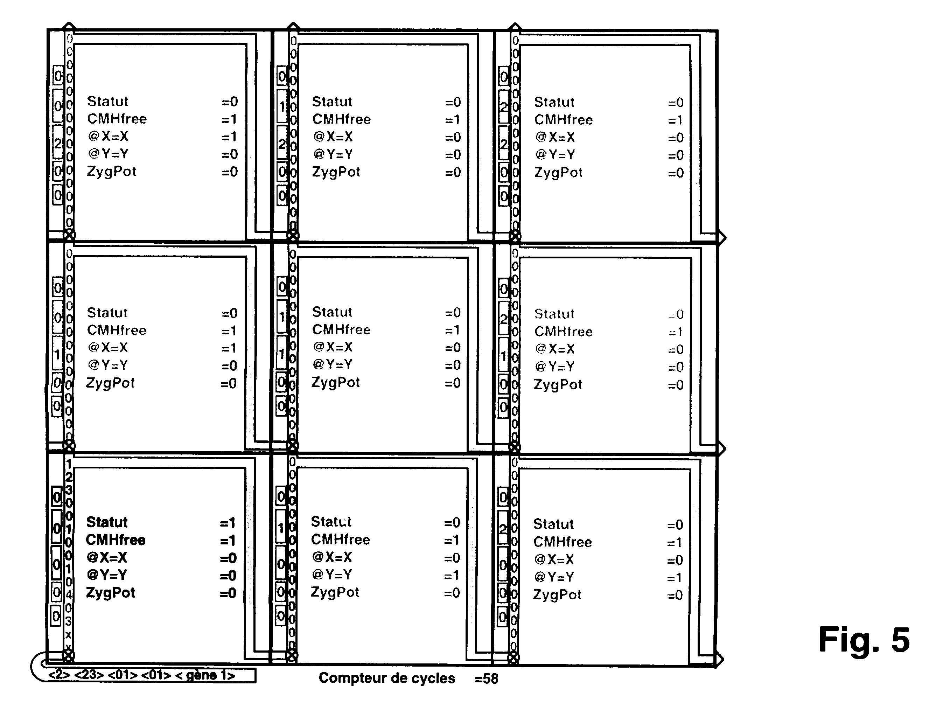

Sur la figure 5, on a représenté la partie du réseau comportant les neuf cellules qui se trouvent à son angle extrême Sud-Ouest. La cellule d'adresse 0,0 vient de recevoir le premier mot de code en entier ce qui, dans l'exemple, demande 58 cycles d'horloge. Dans ces conditions, le code de statut de ce mot de code se trouve, dans le registre à décalage 1, à une position qui lui permet d'être analysé par le module M1 de la cellule d'adresse 0,0. Comme représenté sur la figure 3, le module logique M1 comprend un décodeur 20 qui délivre les signaux de commande du séquenceur en fonction des différentes valeurs du code <statut>. Par exemple, lorsque <statut> vaut 1, la commande START est produite. Les commandes possibles sont résumées dans le tableau 2 ci-dessous :

**TABLEAU 2**

| <statut> | signal engendré |
|---|---|
| 0 | VIDE |
| 1 | START |
| 2 | GENE |
| 3 | FIN_GENOME |
| 4 | MEMBRANE |
| 5 | INTERIEUR |
| 9 | "MORT" |
| 10 | "TEMPERATURE" |

Le module logique M1 comporte également deux éléments de commande de chargement 21 et 22 qui permettent de modifier le code de statut à destination, respectivement, des cellules voisines Nord et Est de la cellule C_{x,y}. Lorsque le code de statut est chargé dans la cellule C_{x,y}, deux registres de statut 20a et 20b reçoivent une copie du code de statut. Chaque registre peut, ou non, être modifié, indépendamment de l'autre, à partir du contenu de deux mémoires de constantes 23 et 24, dépendant de la valeur des signaux de chargement StatutN="" et StatutE="".

Le module logique M2 comporte un comparateur 25 recevant, sur l'une de ses entrées, le code CMH du registre 10 et, sur l'autre entrée, la valeur "0". Ce comparateur 25 délivre un "1" logique (signal CMHFree à "1") à sa sortie lorsque les valeurs appliquées à ses entrées sont toutes deux égales. Ceci signifie que la cellule est encore libre.

Le module logique M2 comporte également un comparateur 26 recevant, sur l'une de ses entrées, le code CMH du registre 10 et, sur l'autre entrée, la valeur provenant du code CMH transitant sur le registre à décalage 1. Ce comparateur 26 délivre un "1" logique (signal CMHIdent à "1") à sa sortie lorsque les valeurs appliquées à ses entrées sont toutes deux égales. Ceci signifie que le mot de code est compatible avec l'organe.

Le module M2 comporte, en outre, un élément de commande de chargement 27 qui permet le chargement du registre 10 avec le numéro d'organe CMH en fonction du signal Load_CMH (Fig. 3).

Les adresses globales @X et @Y du mot de code N°1 ont, respectivement, les valeurs 001 et 001. Lorsque ces valeurs sont respectivement mises en coïncidence dans le registre à décalage 1 de la cellule d'adresse 0,0, les modules M3 et M4 de cette cellule analysent ces valeurs à l'aide des comparateurs 28 et 29. Ceux-ci comportent une première entrée recevant l'adresse globale (respectivement, en X et Y) pendant le chargement des adresses globales décrit précédemment. En l'occurrence, ces comparateurs sont conçus pour délivrer un "1" logique, lorsqu'il y a égalité entre les valeurs appliquées sur leurs entrées, et pour délivrer des "0" logiques lorsque la valeur de l'adresse globale chargée et celle du mot de code sont différentes.

On remarquera sur la figure 3 que les sorties des comparateurs 28 et 29 sont combinés logiquement dans une porte ET 30 délivrant un signal ZygPot sur sa sortie en cas d'égalité des valeurs d'adresse que l'on vient de mentionner. Dans l'exemple, les trois signaux de sortie des comparateurs 28 et 29 et de la porte ET sont à zéro dans la cellule d'adresse 0,0 au passage du premier mot de code (voir Fig. 5) .

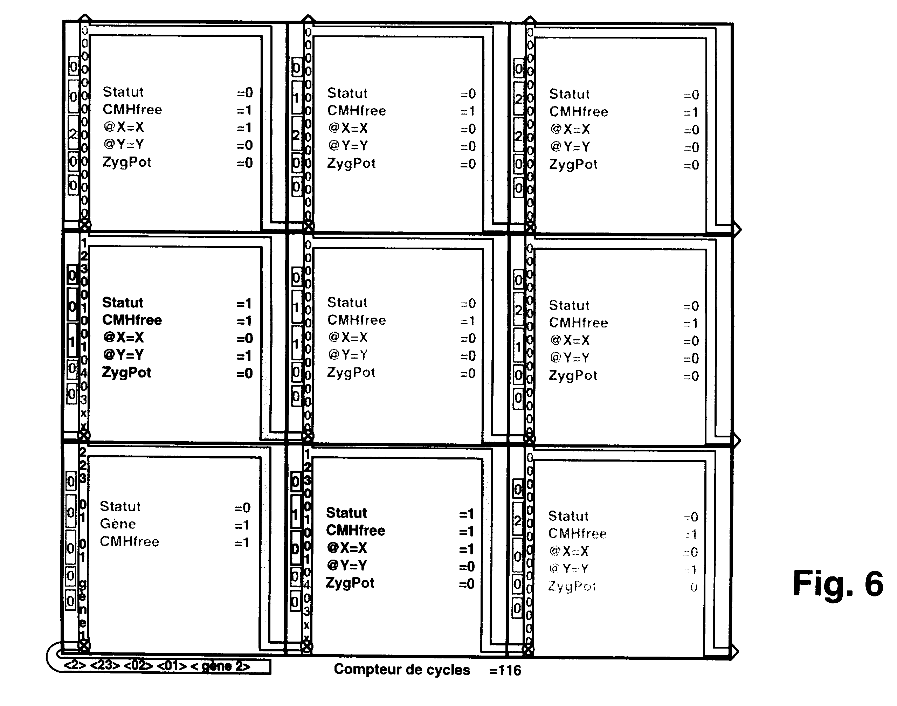

La figure 5 montre également que le mot de code N°2 s'apprête à entrer dans le registre à décalage 1 de la cellule d'adresse 0,0. Pendant les 58 cycles d'horloge suivants, le mot de code N°1 va se propager dans les cellules Est et Nord tandis que la cellule d'adresse 0,0 reçoit le mot de code N°2. Après 116 cycles d'horloge, la situation est alors telle que représentée sur la figure 6, sur laquelle apparaissent les états des signaux fournis par les modules M1 à M4 des cellules concernées. Le mot de code N°3 se présente à l'entrée du registre à décalage 1 de la cellule d'adresse 0,0.

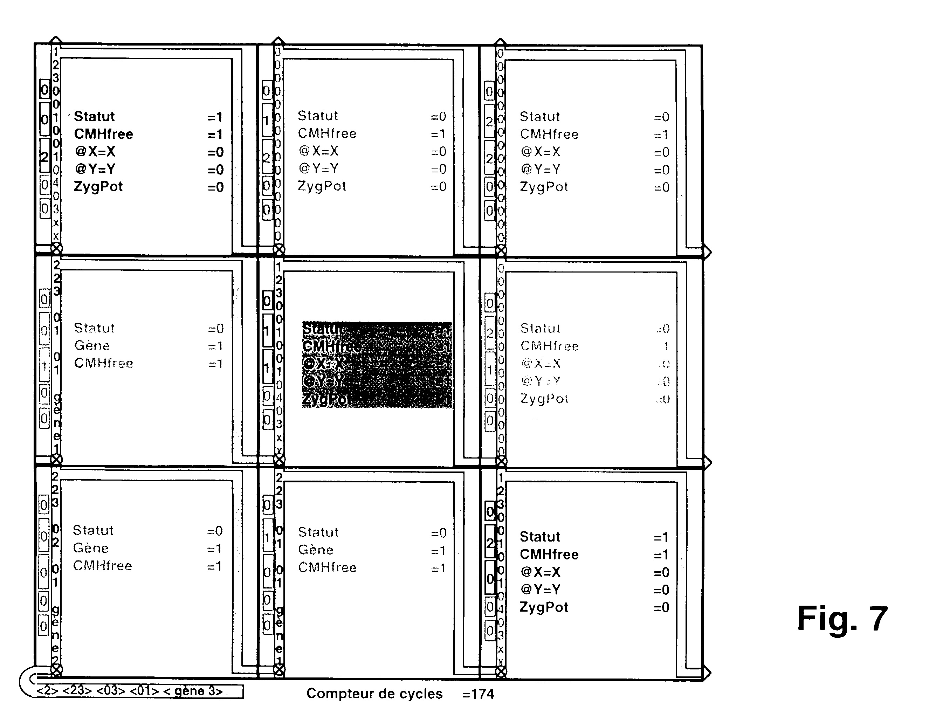

La figure 7 représente la situation lorsque 174 cycles d'horloge se sont écoulés. On voit que le mot de code N°1 se trouve dans les cellules ayant les adresses globales 1,1, 0,2 et 2,0, le mot de code N°2 se trouve dans les cellules ayant les adresses globales 0,1 et 1,0 et le mot de code N° 3 se trouve dans la cellule d'adresse globale 0,0.

L'introduction du mot de code N°1 va provoquer un changement dans la cellule d'adresse 1,1. En effet, dans cette cellule, l'adresse globale correspond aux codes d'adresse globale contenus dans ce mot de code, de sorte que les comparateurs 28 et 29 délivrent maintenant un "1" logique à leur sortie. Ceci va se traduire par un "1" logique à la sortie de la porte ET 30 (ZygPot à "1"). Trois conditions sont ainsi simultanément remplies pour cette cellule; ce qui, dans l'exemple décrit ici, signifie que la cellule en question est la zygote pour l'organe fonctionnel en cours de chargement dans le réseau. Pour ce qui est des autres cellules, on voit sur la figure 7 que rien n'a changé à leur égard, comme le montre l'état indiqué des signaux dans les cellules concernées. Par ailleurs, le mot de code N°4 s'apprête à entrer dans la cellule d'adresse 0,0.

Dans la cellule d'adresse globale 1,1 que l'on appellera désormais zygote, les états logiques "1" des deux signaux START (<statut=1>) et ZygPot provoquent le déclenchement d'une porte ET 31 (figure 3B), dont la sortie Start_Zyg signifie que l'on a trouvé la zygote correspondant au génome en cours de chargement. Ce signal, combiné à l'état "1" du signal CMHfree, provoque le déclenchement d'une porte ET 32 dont la sortie est le signal Load_Zygote, qui signifie que la zygote potentielle est libre et qu'on peut la charger. Ce signal forme avec les signaux Load_Membrane et Load_Intérieur les cas de chargement du CMH, comme réalisé par la porte OU 35 qui fournit le signal Load_CMH déclenchant tout le fonctionnement de création de la membrane et, en particulier, le chargement du registre de CMH grâce à l'élément de chargement 27.

Le séquenceur de chaque cellule comprend un ensemble de portes logiques (Fig. 3A), permettant :
- de générer le code de membrane stocké dans les bascules 62 (CM2), 63 (CM1) et 64 (CM0),
- d'initialiser la bascule M de membrane 58,
- et de générer les signaux de modification du code de statut pour la transmission aux cellules voisines Nord et Est (StatutN et StatutE).

La bascule de membrane 58 est initialisée, soit par l'arrivée du signal Load_Zygote, soit par l'arrivée du code <statut=4> (indiquant une cellule de membrane, voir tableau 2). La porte logique OU 57 permet de réaliser cette fonction.

Le code membranaire CM=0 caractérisant la cellule zygote est établi directement par la ligne Load_Zygote (figure 3A) .

Les autres codes membranaires nécessitent tous la présence du signal de création de membrane <Statut=4>. Les portes logiques ET 50 à 56 permettent d'engendrer les commandes CM=1 à CM=7, comme indiqué à la figure 3A

Pour créer les différentes valeurs du code membranaire, on peut dresser le tableau suivant :

**TABLEAU 3**

| | | | |
|---|---|---|---|
| CM = 0 | si Load_Zygote | | |
| CM = 1 | si <statut = 4> | ET 1 < x < δx | ET y = 1 |
| CM = 2 | si <statut = 4> | ET x = δx | ET y = 1 |
| CM = 3 | si <statut = 4> | ET x = δx | ET 1 < y < δy |
| CM = 4 | si <statut = 4> | ET x = 1 | ET 1 < y < δy |
| CM = 5 | si <statut = 4> | ET x = 1 | ET y = δy |
| CM = 6 | si <statut = 4> | ET 1 < x < δx | ET y = δy |
| CM = 7 | si <statut = 4> | ET x = δx | ET y = δy |

Ces signaux servent à établir la valeur binaire du code de membrane chargé dans les bascules 62, 63 et 64 grâce aux portes logiques OU 59, 60 et 61.

Le code de statut formant la première partie des mots de code du génome est utilisé pour affecter aux cellules leur statut, à savoir notamment si elles sont en dehors de l'organe fonctionnel, appartiennent à la membrane de celui-ci ou font partie des cellules situées dans l'organe lui-même. La figure 3A illustre schématiquement un exemple de la façon dont le séquenceur 4 peut engendrer le code de statut à l'aide des signaux de génération du code membranaire. Ces signaux, seuls ou en combinaison grâce aux portes logiques 65 à 76, permettent la génération des nouveaux codes de statut nécessaires à la croissance de l'organe. A cet effet, les signaux StatutN = "..." et StatutE = "..." permettent, au moment du passage du mot de code de statut du génome dans le registre à décalage 1, de forcer le code de statut correspondant pour l'envoyer aux cellules Nord et Est.

Le code de statut présent dans le mot de code est ainsi remplacé par cette nouvelle valeur pour attribuer à la cellule, qui va recevoir ensuite ce mot de code, son statut par rapport à l'organe en cours de croissance.

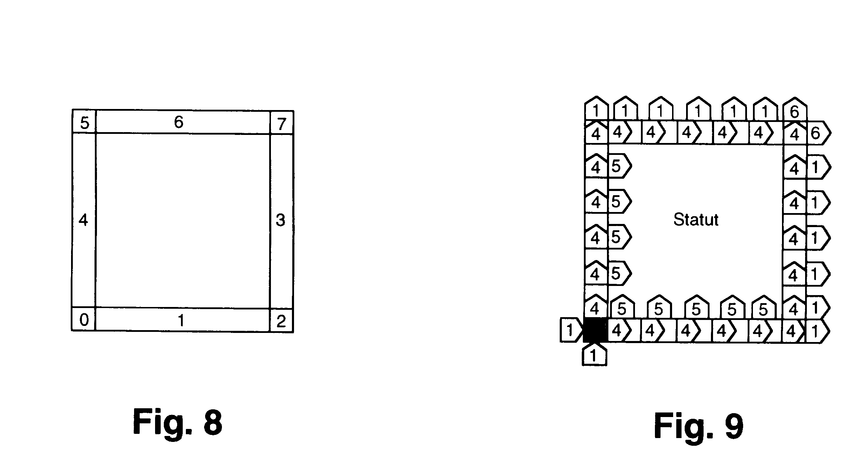

La figure 8 résume à quelles cellules de membrane de l'organe O sont respectivement affectés les codes de membrane CM. On voit que la zygote conserve son code 0, les cellules de membrane Sud ont un code de membrane 1, la cellule de membrane de l'angle Sud-Est a le code 2, les cellules de membrane Est ont le code 3, les cellules de membrane Ouest ont le code 4, la cellule de membrane de l'angle Nord-Ouest a le code 5, les cellules de membrane Nord ont le code 6 et, enfin, la cellule de membrane Nord-Est le code 7.

Il est évident que ces affectations de la valeur du code de membrane ne sont données qu'à titre d'exemple.

La figure 9 résume, pour toutes les cellules de l'organe, quel sera le code de statut de la cellule concernée, remplacé au cours de la croissance de cet organe. Ce remplacement se fait selon le tableau 4 suivant (donné également à titre purement illustratif):

**TABLEAU 4**

| Code de membrane | <Code de statut> Voisine Est | <Code de statut> Voisine Nord |
|---|---|---|
| 0 | 4 | 4 |
| 1 | 4 | 5 |
| 2 | 1 | 4 |
| 3 | 1 | 4 |
| 4 | 5 | 4 |
| 5 | 4 | 1 |
| 6 | 4 | 1 |
| 7 | 6 | 6 |

La figure 9 montre ainsi que certaines valeurs du code de statut dans chaque mot de code ont les significations suivantes:
- <statut 1>=: en-tête du génome
- <statut 4>=: croissance d'une membrane
- <statut 5>=: intérieur de l'organe
- <statut 6>=: croissance membrane terminée.

Dès que la zygote est chargée, le calcul d'adresse locale est initialisé. Ceci est réalisé par une initialisation à "1" des registres d'adresses locales 9 par le signal Load_Zygote commandant les multiplexeurs 33 et 34 (figure 3). Le calcul d'adresse est maintenu effectif sur toute la surface de la membrane par le signal Load_CMH engendré par la porte OU 35 (figure 3B) à partir du signal Load_Membrane (sortie de la porte ET 91), du signal Load_Intérieur (sortie de la porte logique ET 93) et du signal Load_Zygote. Le signal Load_CMH permet d'activer l'élément de chargement 36 pour charger les registres 9 stockant l'adresse locale.

Les adresses locales sont affectées aux cellules, en principe, de la même façon que celle décrite ci-dessus pour l'affectation des adresses globales, tout au moins pour ce qui concerne les cellules répondant aux conditions suivantes:
Code de statut = <statut 5>
M=1 ET CM=6 (Partie Nord de la membrane)
M=1 ET CM=3 (Partie Est de la membrane)
M=1 ET CM=7 (Angle Nord-Est de la membrane)

Les autres cellules (bord Sud de l'organe et bord Ouest de l'organe) sont traitées comme les cellules situées sur les bords Sud et Ouest du réseau. Lors du calcul d'adresse globale, elles reçoivent les valeurs incrémentées correspondantes selon la valeur portée par les lignes BordSud et BordWest pilotant les multiplexeurs 13 et 16.
BordSud = BordSud_Réseau OU BordSud_Organe
BordWest = BordWest_Réseau OU BordWest_Organe
BordSud_Organe = (M=1) ET (CM=4) OU (CM=5)
BordWest_Organe = (M=1) ET(CM=1) OU (CM=2)

Le bloc M5 d'adresse locale δx comporte deux comparateurs 37 et 38 qui permettent, avec la porte ET 39, de générer les signaux x=1, 1 < x < δx, et x = δx utilisés pour la génération du code membranaire.

Le bloc M6 d'adresse locale δy comporte également deux comparateurs 40 et 41 qui permettent, avec la porte ET 42, de générer les signaux y=1, 1 < y < δy et y = δy_utilisés pour la génération du code membranaire.

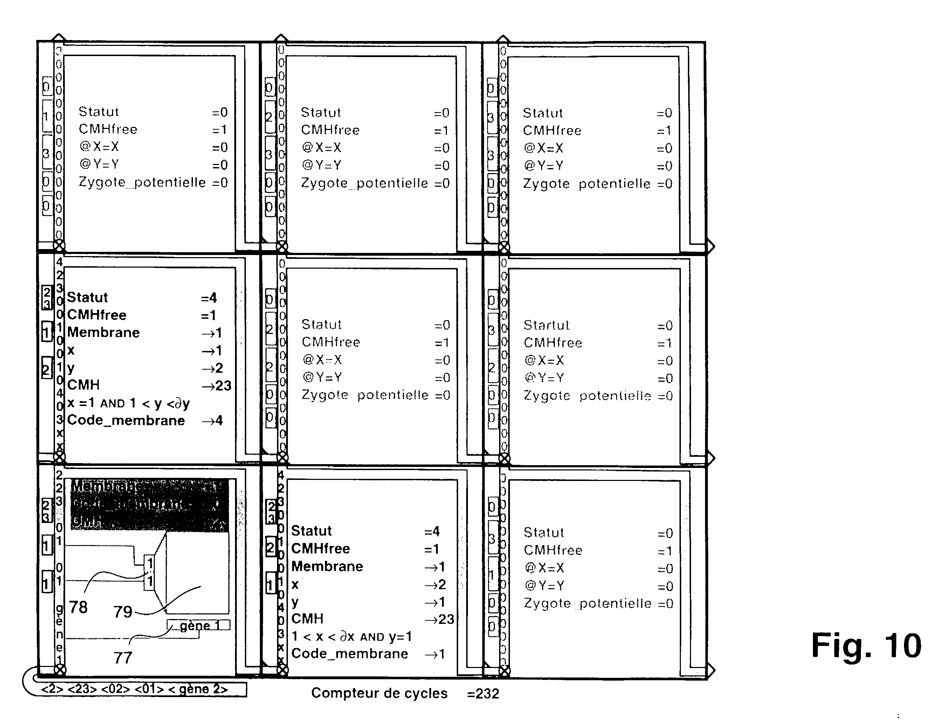

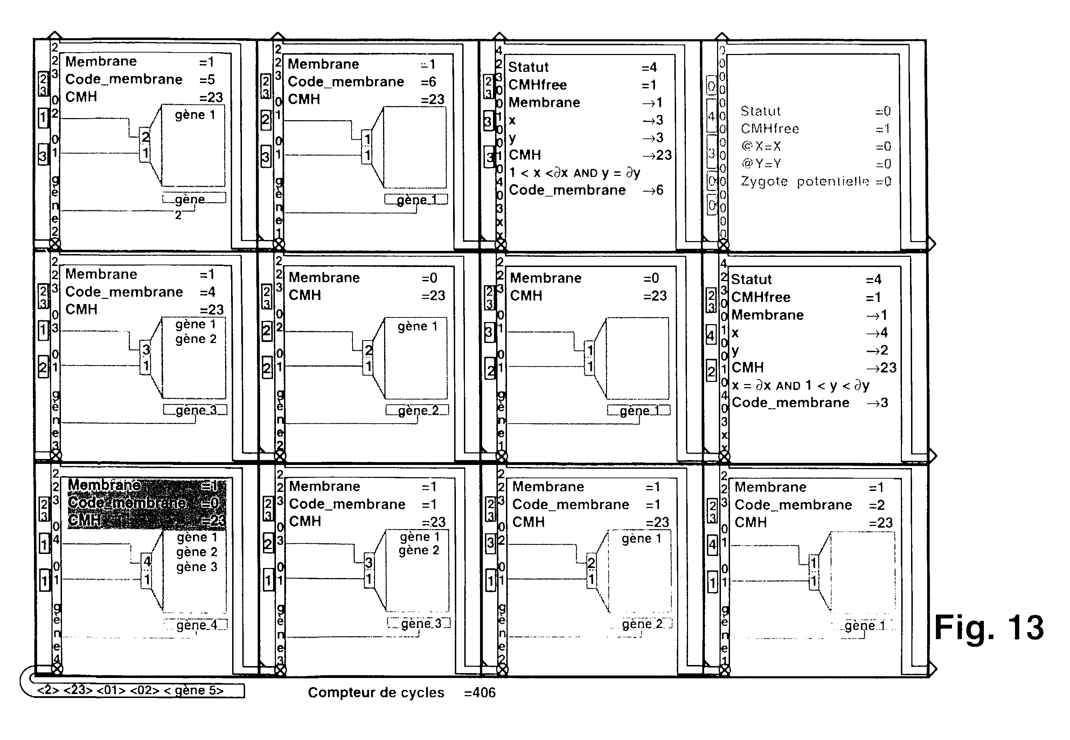

Les figures 10 à 14 illustrent la croissance de l'organe 0 à partir de la zygote d'adresse globale 1,1 selon le génome qui a été indiqué dans le tableau 1 ci-dessus. Sur chaque figure, on a représenté l'état des signaux et codes dans la cellule pour en illustrer l'état.

Sur la figure 10, la zygote contient le mot de code N°2, tandis que les cellules d'adresse globale 1,2 et 2,1 ont reçu le mot de code N°1 dans lequel le code de statut a été modifié de 1 à 4 par les éléments de chargement 21 et 22, à partir des mémoires de constantes 23 et 24 (Fig. 3), de la zygote. Les autres cellules sont encore inactivées n'ayant encore reçu aucun mot de code. On notera que le code de statut 4 affecte désormais, aux cellules d'adresse 1,2 et 2,1, le statut de cellule de membrane. Le compteur de cycles dans chacune des cellules marque maintenant 232. Le premier gène du génome est placé dans le registre 77 de la zygote. Le décodeur 78 est chargé avec les adresses locales du gène δx et δy. Le contenu du registre 77 est alors chargé en mémoire 79, grâce au signal Load_génome fourni par la porte ET 98 (Fig. 3B) .

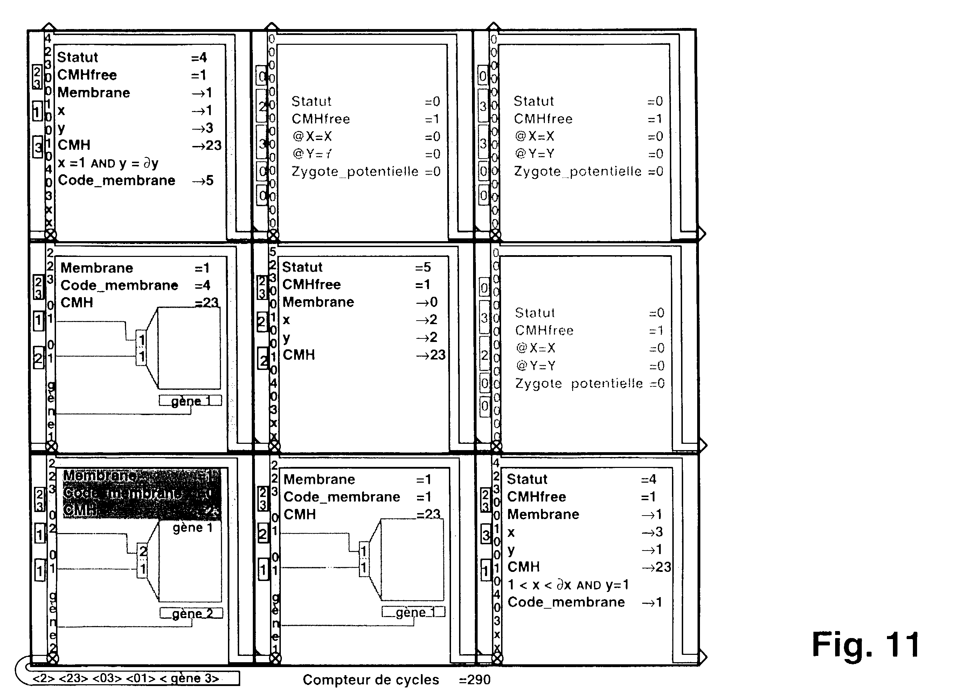

Sur la figure 11, les compteurs de cycles des cellules marquent 290. Le mot de code N°3 est entré dans la zygote. Les cellules d'adresse 1,3 et 3,1 ont vu leur code de statut changé en <statut 4>, tandis que pour la cellule d'adresse 2,2 ce code de statut a été changé en <statut 5>. Celle-ci devient donc une cellule interne à l'organe O.

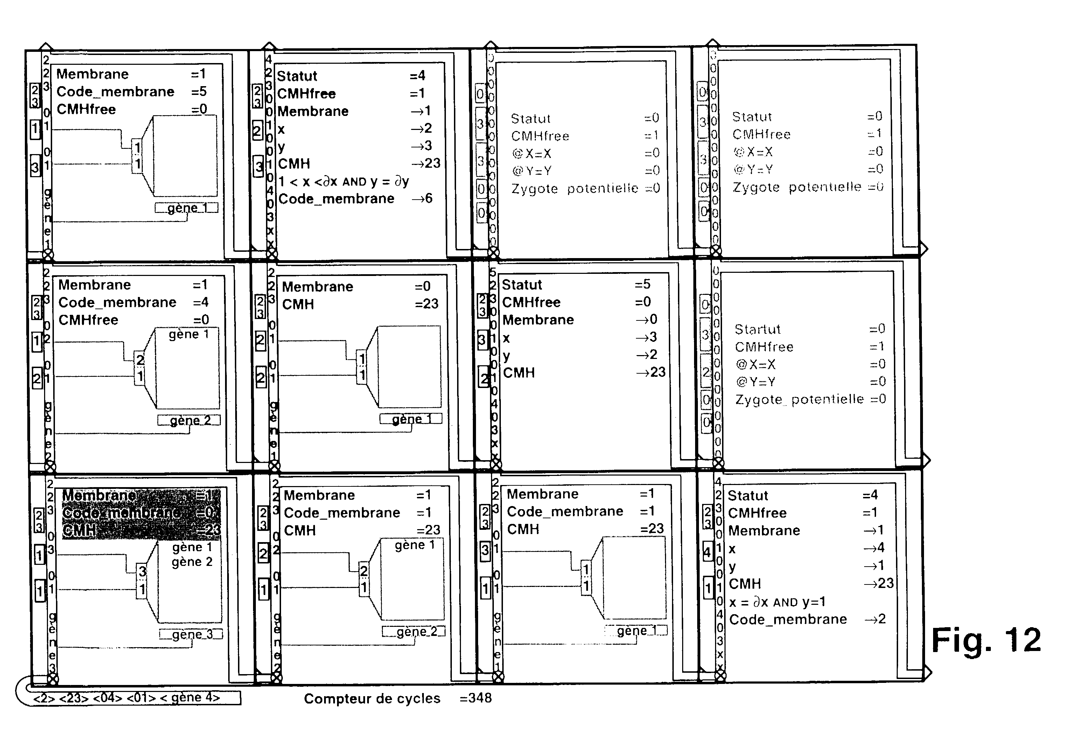

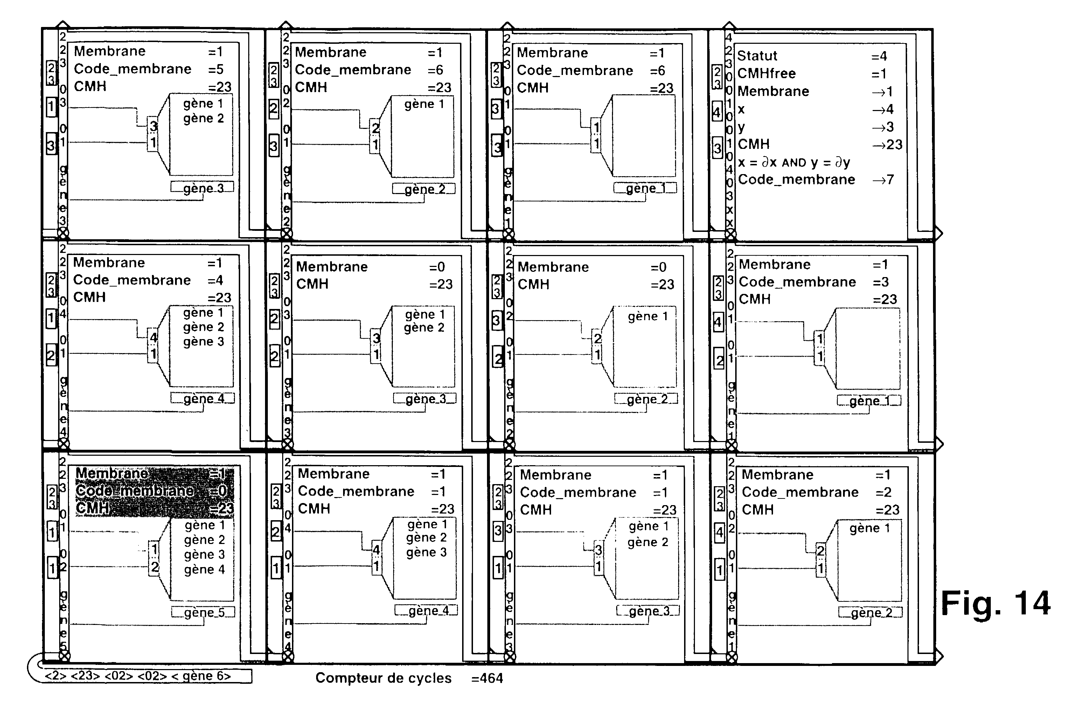

Les figures 12, 13 et 14 montrent la situation respectivement après 348, 406 et 464 cycles de l'horloge de base du processeur P, la figure 14 représentant, pour ce qui concerne la zygote, le passage du gène N°5.

La croissance de l'organe O se poursuit ainsi jusqu'à ce que le mot de code N°1 atteigne la cellule extrême nord-est de l'organe O.

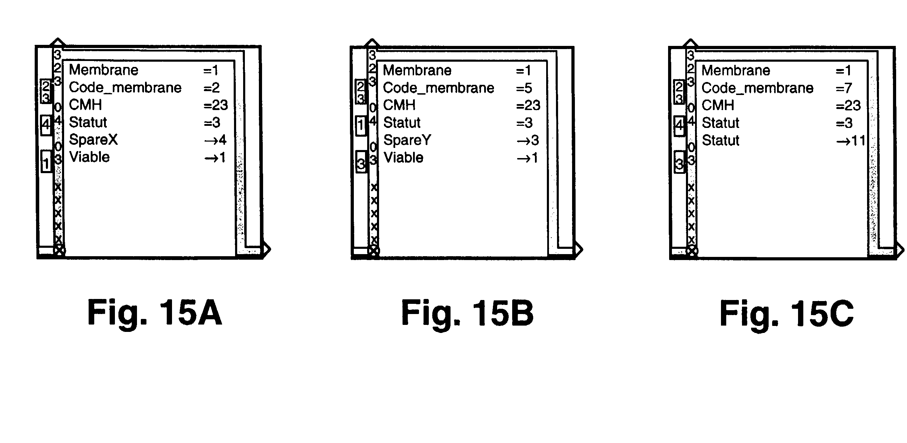

Toutefois, les cellules extrêmes Sud-Est (adresse 4,1) de code de membrane CM=2, Nord-Ouest (adresse 1,3) de code de membrane CM=5 et Nord-Est (adresse 4,3) de code de membrane CM=7 subissent une opération particulière comme représenté sur les figures 15A, 15B et 15C, grâce à la forme particulière du mot de code N°14 du génome dont le code de statut est <statut=3>. Lorsque le mot de code final N° 14 arrive dans la cellule de l'angle Sud-Est de la membrane, le code SPAREX du mot de code est chargé dans un registre SPAREX de la cellule. Le chargement est commandé par la porte ET 43a dont les entrées sont les signaux Fin_génome (<Statut = 3>) et le signal CM = 2. Tant que la partie d'adresse locale x de cette cellule est inférieure (ou égale) au contenu du registre SPAREX, un signal VIABLE=1 est activé par le comparateur 46.

Si la cellule est celle correspondant à l'angle Nord-Ouest (CM5) le registre SPAREY réalise la même fonction. Le chargement est commandé par la porte ET 43b dont les entrées sont les signaux Fin_génome (<Statut = 3>) et le signal CM = 5. Tant que la partie adresse locale δy de cette cellule est inférieure ou égale au contenu du registre SPAREY, un signal VIABLE=1 est activé par le comparateur 48.

Il est à noter que, dans l'exemple décrit, le code SPARE se confond avec l'adresse locale de la dernière cellule de l'organe O. Toutefois, ce code peut être utilisé pour réserver un certain nombre de cellules comme des cellules de réserve capables de remplacer, le cas échéant, des cellules défectueuses.

Ces signaux VIABLE (qui peuvent être différenciés en X et en Y) sont utilisés lors de la "prise de température" (code <statut = 10>) pour fournir une indication de l'état des réserves. Les portes ET 44 sont alors utilisées pour copier les registres SPARE dans le registre à décalage à la place des registres δx et δy. Les éléments de chargement 45 et 47 sont utilisés pour ces opérations.

Lors du chargement d'un organe, il est judicieux de prévoir un surplus de cellules destinées à remplacer d'éventuelles cellules fonctionnelles tombant en panne. Un tel remplacement est géré par le circuit 7 de gestion des pannes et peut être effectué comme indiqué dans la demande précitée. De plus, comme indiqué précédemment, il est possible de connaître le nombre restant de cellules en surplus. Ce nombre est associé, dans la présente description, à la "température" de l'organe, qui est une information transmise au processeur P.

Si la cellule se trouve à l'angle Nord-Est le code de statut est changé dans le mot de code N°1 pour prendre la valeur 6, ce qui signifie la fin de la croissance de l'organe O.

Différents problèmes (pannes, erreurs, etc.) peuvent survenir lors du chargement d'un organe ou lors de l'utilisation du système. Ce dernier est équipé de moyens permettant de traiter ces problèmes.

C'est le cas lorsque la zygote potentielle est déjà occupée. On ne peut alors pas effectuer le chargement de l'organe. A partir du signal Start_Zyg engendré par la porte ET 31 (figure 3B), et du signal CMHfree = 0 (qui signifie que la cellule est déjà occupée), la porte 90 produit le signal <code_erreur = 1>.

Un second cas se produit lorsque la croissance de la membrane rencontre une cellule déjà occupée. On ne peut alors pas effectuer le chargement de l'organe. A partir du signal Membrane (<Statut = 4>) et du signal CMHfree=0 (qui signifie que la cellule est déjà occupée), la porte 92 produit le signal <code_erreur = 2>.

Un troisième cas se produit lorsque la croissance de l'organe (intérieur cette fois) rencontre une cellule déjà occupée. On ne peut alors pas effectuer le chargement de l'organe. A partir du signal Intérieur (<Statut = 5>) et du signal CMHfree=0 (qui signifie que la cellule est déjà occupée), la porte 94 délivre le signal <code_erreur = 3>.

Les différents signaux d'erreur (<code_erreur = 1> à <code_erreur = 3>) forment les entrées d'une porte OU 71 (figure 3A) dont la sortie est le code <Statut = 8> (Nord et Est). Ce signal est utilisé pour modifier le code de statut.

Ce code d'erreur est aussi utilisé pour activer un multiplexeur qui permet de sélectionner la constante de code d'erreur stockée dans la mémoire 81 et de la charger à la place du mot de code (gène) grâce au signal <Statut = 8> commandant l'élément de chargement 80.

Il existe un mode de défaillance encore plus grave, qui est une panne d'une cellule de la membrane; que ce soit lors du chargement ou lors de l'utilisation. La détection de ce cas est obtenue par la porte OU 95 (figure 3B) dont les entrées sont Load_Zygote, Load_Membrane, et la sortie de la bascule M58 (figure 3A). La sortie de cette porte 95 forme une entrée de la porte ET 96 dont la seconde entrée est le signal de panne provenant du bloc 7 de gestion des pannes (figure 2). La sortie de cette porte ET 96 est directement connectée sur l'entrée "set" d'une bascule 98 appelée Défaut_majeur. Cette bascule est déclenchée sur un signal global de ligne et un signal global de colonne pour indiquer le défaut majeur. Le processeur P prend alors en charge la reconfiguration de l'organe, comme indiqué ci-dessus.

Le signal de sortie de la bascule 98 Défaut_majeur est également utilisé pour fournir un compte-rendu de la panne (ainsi que de l'emplacement où a eu lieu le problème). A cet effet, il est combiné, dans la porte 72, au signal vide (<statut = 0>), qui indique que le registre à décalage 1 est libre, pour transmettre un code de statut (<Statut = 9>) à destination du processeur P, via les cellules voisines Nord et Est. Cette constante du code d'erreur permet, par exemple, au processeur P (ou à tout autre organe spécialisé) de relancer le chargement de l'organe en modifiant par, exemple, l'adresse globale de sa zygote.

Il est clair que l'échange de signaux fonctionnels entre les organes, tels que les signaux de sortie de la partie fonctionnelle programmable 6, peut être effectué par des cellules de membrane lorsque les organes sont adjacents ou par des organes spécialement dédicacés (organes de connexion) reliant des organes disjoints.

Par ailleurs, il est bien évident que la présente invention peut également s'appliquer à des réseaux ayant une hiérarchie plus complexe. Ainsi, peut-on envisager des réseaux comportant des organismes différents, chacun étant constitué de plusieurs organes différents.

## Revendications

1. Réseau matriciel (R) composé de cellules (C_{xy}) toutes de construction identique et dans lequel à chaque cellule est affecté un mot de code qui en définit la fonction qu'elle doit assurer au sein du réseau (R), ledit réseau comportant des moyens (1) qui, en vue de la configuration des cellules (C_{xy}), font translater itérativement dans chacune desdites cellules un génome formé d'un train desdits mots de code successifs, caractérisé en ce qu'il comprend au moins un organe fonctionnel (O1, O2, O3,....) individualisé composé d'une pluralité desdites cellules qui sont toutes caractérisées par un même premier code prédéterminé (<CMH>) faisant partie dudit mot de code et formé par un numéro identifiant ledit organe (O1, O2, O3,....) et organisées de manière à assurer collectivement la fonctionnalité dudit organe, lesdites cellules de l'organe étant réparties en un premier groupe de cellules dites internes définies par une première valeur (<statut = 5>) prédéterminée d'un second code ou code de statut faisant également partie dudit mot de code, et un second groupe de cellules dites de membrane et définies par une seconde valeur prédéterminée (<statut = 4>) dudit second code, ledit premier groupe de cellules assurant la fonctionnalité dudit organe et ledit second groupe de cellules formant membrane (MO1, MO2, MO3,....) étant capable d'isoler fonctionnellement ledit premier groupe de cellules du reste du réseau et assurant la communication de ce premier groupe de cellules avec le reste dudit réseau (R).

2. Réseau matriciel suivant la revendication 1, caractérisé en ce que lesdites cellules internes sont configurées pour former dans ledit organe (O1, O2, O3,....) un premier ensemble de cellules assurant la fonctionnalité de cet organe et un second ensemble de cellules configurées pour être des cellules de réserve (code SPARE), chaque cellule (C_{xy}) comprenant également des moyens (7, 90 à 99) pour engendrer un signal de panne en cas de dysfonctionnement de cette cellule, et des moyens pour, en réponse audit signal de panne, remplacer la cellule en panne par une cellule prise dans ledit ensemble de cellules de réserve.

3. Réseau matriciel suivant la revendication 2, caractérisé en ce que chaque cellule comprend également des moyens (registres SPARE) pour permettre une comptabilisation du nombre de cellules restant disponibles dans ledit ensemble de cellules de réserve et pour engendrer une information d'alarme modifiant dans ledit génome ledit second code affecté à la cellule considérée (<statut = 10>) en fonction du résultat de cette comptabilisation.

4. Réseau matriciel suivant l'une quelconque des revendications 1 à 3, caractérisé en ce que chaque cellule est équipée de moyens (8) pour mémoriser une adresse globale (@X, @Y) définissant son emplacement dans ledit réseau (R), et des moyens de comparaison d'adresse (M3, M4) pour engendrer un signal d'identification (ZygPot) lorsque, pendant le transfert dudit génome, un mot de code contient des valeur d'adresse identiques à celles de l'adresse globale mémorisée dans ladite cellule, ledit signal étant capable d'initier la configuration de ladite cellule considérée en tant que zygote d'un organe fonctionnel (O1, O2, O3,....).

5. Réseau matriciel suivant l'une quelconque des revendications précédentes, caractérisé en ce que chaque cellule comporte des moyens (20) pour analyser ledit second code (<statut>) des mots de code composant ledit génome et des moyens (4, 20a, 20b, 21, 22, 23, 24) pour modifier ledit second code dans le mot de code qui est présent dans la cellule considérée, pour transmettre une information de code de statut modifié en aval dans ledit réseau pendant le transfert dudit génome, soit à au moins une autre cellule, soit à un processeur général (P) gérant le fonctionnement dudit réseau.

6. Réseau matriciel suivant les revendications 4 et 5 en tant que dépendant de la revendication 4, caractérisé en ce que chaque cellule comporte des moyens (M5, M6) capables d'analyser une information de taille d'organe (δx, δy) contenue dans au moins certains des mots de code dudit génome, lorsque ladite zygote ou une cellule située en amont par rapport à la cellule considérée pendant le transfert dudit génome mais en aval par rapport à ladite zygote, transmet ledit second code modifiée à la cellule considérée, et des moyens (50 à 76) pour, en fonction de ladite analyse, se configurer en tant cellule de membrane (<statut = 4> ou cellule fonctionnelle (<statut = 5>) dudit organe.

7. Réseau matriciel suivant la revendication 6, caractérisé en ce que chaque cellule comporte des moyens (12) pour permettre un calcul redondant d'adresse desdites cellules (C_{xy}) selon des directions croisées de la matrice dudit réseau.

## Patentansprüche

1. Matrixförmiges Netz (R), das aus Zellen (C_{xy}) jeweils identischen Aufbaus zusammengesetzt ist und in dem jeder Zelle ein Codewort zugeordnet ist, das die von ihr innerhalb des Netzes (R) auszuübende Funktion definiert, wobei das Netz Mittel (1) aufweist, die im Hinblick auf die Konfiguration der Zellen (C_{xy}) in jeder der Zellen ein von einem Zug aufeinanderfolgender Codewörter gebildetes Genom iterativ verschieben, dadurch gekennzeichnet, daß es mindestens ein individualisiertes funktionales Organ (01, 02, 03,...) aufweist, das aus einer Anzahl der Zellen besteht, die sämtlich durch einen vorgegebenen gleichen ersten Code (<CMH>) charakterisiert sind, welcher einen Teil des besagten Codewortes bildet und von einer das Organ (01, 02, 03,...) identifizierenden Zahl gebildet wird, und die so organisiert sind, daß sie gemeinsam die Funktionalität des Organs sicherstellen, wobei die Zellen des Organs verteilt sind in einer ersten Gruppe von sogenannten internen Zellen, die durch einen ersten vorgegebenen Wert (<Statut = 5>) eines zweiten Codes bzw. Statut-Codes definiert sind, der ebenfalls Teil des besagten Codewortes bildet, und einer zweiten Gruppe von sogenannten Membran-Zellen und definiert sind durch einen zweiten vorgegebenen Wert (<Statut = 4>) des zweiten Codes, wobei die erste Gruppe von Zellen die Funktionalität des Organs sicherstellen und die zweite Gruppe von membranbildenden Zellen (M01, M02, M03, ...) in der Lage ist, die erste Gruppe von Zellen gegenüber dem Rest des Netzes funktional zu isolieren und die Kommunikation dieser ersten Gruppe von Zellen mit dem Rest des Netzes (R) sicherzustellen.

2. Matrixförmiges Netz nach Anspruch 1, dadurch gekennzeichnet, daß die internen Zellen so konfiguriert sind, daß sie in dem Organ (01, 02, 03,...) eine erste Menge an die Funktionalität dieses Organs sicherstellenden Zellen und eine zweite Menge an Zellen bilden, die so konfiguriert sind, daß sie Reservezellen sind (Code SPARE), wobei jede Zelle (C_{xy}) ferner aufweist: Mittel (7, 90 bis 99) zum Erzeugen eines Fehlersignals im Fall einer Fehlfunktion dieser Zelle sowie Mittel zum Ersetzen der fehlerhaften Zelle in Abhängigkeit von dem Fehlersignal durch eine Zelle, die der Menge der Reservezellen entnommen ist.

3. Matrixförmiges Netz nach Anspruch 2, dadurch gekennzeichnet, daß jede Zelle ferner aufweist: Mittel (Register SPARE) zum Ermöglichen einer Buchung der Anzahl der in der Menge der Reservezellen verbliebenen Zellen und zum Erzeugen einer Warninformation, die in dem Genom den der betrachteten Zelle (<Statut = 10>) zugeordneten zweiten Code in Abhängigkeit von dem Ergebnis dieser Buchung modifiziert.

4. Matrixförmiges Netz nach einem der Ansprüche 1 bis 3, dadurch gekennzeichnet, daß jede Zelle ausgerüstet ist mit Mitteln (8) zum Speichern einer globalen Adresse (@X, @Y), die ihre Stelle in dem Netz (R) definiert, und Adressenvergleichsmitteln (M3, M4) zum Erzeugen eines Identifizierungssignals (ZygPot) wenn während der Übertragung des besagten Genoms ein Codewort Adressenwerte enthält, die identisch sind zu denen der in der besagten Zelle gespeicherten globalen Adresse, wobei dieses Signal in der Lage ist, die Konfiguration der betrachteten Zelle als Zygote eines funktionalen Organs (01, 02, 03,...) zu initiieren.

5. Matrixförmiges Netz nach einem der vorhergehenden Ansprüche, dadurch gekennzeichnet, daß jede Zelle aufweist: Mittel (20) zum Analysieren des zweiten Codes (<Statut>) der das besagte Genom bildenden Codewörter sowie Mittel (4, 20a, 20b, 21, 22, 23, 24) zum Modifizieren des zweiten Codes in dem Codewort, das in der betrachteten Zelle vorhanden ist, um eine Information des Statut-Codes, das vorher in dem Netz während der Übertragung des besagten Genoms modifiziert wurde, zu übertragen entweder an mindestens eine andere Zelle oder an einen allgemeinen Prozessor (P), der den Betrieb des Netzes leitet.

6. Matrixförmiges Netz nach einem der Ansprüche 4 und 5, sofern von Anspruch 4 abhängig, dadurch gekennzeichnet, daß jede Zelle aufweist: Mittel (M5, M6), die in der Lage sind, eine Information hinsichtlich der Organgröße (δx, δy), die in mindestens bestimmten Codewörtern des besagten Genoms enthalten ist, zu analysieren, wenn die besagte Zygote oder eine Zelle, die während der Übertragung des besagten Genoms stromauf bezüglich der betrachteten Zelle, jedoch stromab bezüglich der besagten Zygote angeordnet ist, den zweiten modifizierten Code auf die betrachtete Zelle überträgt, sowie Mittel (50 bis 76), die sich in Abhängigkeit von dieser Analyse als Membran-Zelle (<Statut = 4>) oder als funktionale Zelle (<Statut = 5> des Organs ausbilden.

7. Matrixförmiges Netz nach Anspruch 6, dadurch gekennzeichnet, daß jede Zelle aufweist: Mittel (12) zum Ermöglichen einer redundanten Berechnung der Adresse der besagten Zellen (C_{xy}) in sich kreuzenden Richtungen der Matrix des Netzes.

## Claims

1. A matrix network (R) composed of cells (Cx,y) all of identical construction and in which network each cell is assigned a code word which defines its function which it is to provide for within the network (R), said network including means (1) which, with a view to the configuring of the cells (Cx,y), iteratively cause the translation into each of said cells of a genome formed of a train of said successive code words, wherein it comprises at least one individualized functional organ (O1, O2, O3, ...) composed of a plurality of said cells which are all characterized by a same first predetermined code (<MHC>) forming part of said code word and formed by a number identifying said organ (O1, O2, O3, ...) and are organized in such a way as collectively to provide for the functionality of said organ, said cells of the organ being distributed as a first group of so-called internal cells defined by a first predetermined value (<status = 5>) of a second code or status code also forming part of said code word, and a second group of so-called membrane cells defined by a second predetermined value (<status = 4>) of said second code, said first group of cells providing for the functionality of said organ and said second group of membrane-forming cells (MO1, MO2, MO3, ...) being capable of functionally isolating said first group of cells from the remainder of the network and providing for the communication of this first group of cells with the remainder of said network (R).

2. The matrix network as claimed in claim 1, wherein said internal cells are configured so as to form in said organ (O1, O2, O3, ...) a first set of cells providing for the functionality of this organ and a second set of cells configured so as to be reserve cells (code SPARE), each cell (Cx,y) also comprising means (7, 90 to 99) for generating a fault signal in the event of the malfunctioning of this cell, and means for, in response to said fault signal, replacing the faulty cell with a cell taken from said set of reserve cells.

3. The matrix network as claimed in claim 2, wherein each cell also comprises means (SPARE registers) for allowing a counting of the remaining number of cells available in said set of reserve cells and for generating an alarm cue modifying in said genome said second code assigned to the relevant cell (<status = 10>) depending on the result of this counting.

4. The matrix network as claimed in any one of claims 1 to 3, wherein each cell is equipped with means (8) for storing a global address (@X, @Y) defining its location in said network (R), and address comparison means (M3, M4) for generating an identification signal (ZygPot) when, during the transfer of said genome, a code word contains address values identical to those of the global address stored in said cell, said signal being capable of initiating the configuring of said relevant cell as a zygote of a functional organ (O1, O2, O3, ...).

5. The matrix network as claimed in any one of the preceding claims, wherein each cell includes means (20) for analyzing said second code (<status>) of the code words of which said genome is composed and means (4, 20a, 20b, 21, 22, 23, 24) for modifying said second code in the code word which is present in the relevant cell, so as to transmit a modified status code cue downstream in said network during the transfer of said genome, either to at least one other cell, or to a general processor (P) managing the operation of said network.

6. The matrix network as claimed in claims 4, and 5, as far as it depends from claim 4 wherein each cell includes means (M5, M6) capable of analyzing an organ size cue (δx, δy) contained in at least some of the code words of said genome, when said zygote or a cell situated upstream with respect to the relevant cell during the transfer of said genome but downstream with respect to said zygote, transmits said second modified code to the relevant cell, and means (50 to 76) for, depending on said analysis, configuring themselves as a membrane cell (<status = 4>) or functional cell (<status = 5>) of said organ.

7. The matrix network as claimed in claim 6, wherein each cell includes means (12) for allowing a redundant computation of address of said cells (Cx,y) in cross directions of the matrix of said network.
